Europäisches Patentamt

European Patent Office

Office européen des brevets

(19)

(11) Veröffentlichungsnummer: **0 185 255 B1**

# EUROPÄISCHE PATENTSCHRIFT

(12)

(45) Veröffentlichungstag der Patentschrift: **06.11.91**

(51) Int. Cl.⁵: **G01R 31/02**

(21) Anmeldenummer: **85115412.0**

(22) Anmeldetag: **04.12.85**

(54) Verfahren zur Polaritätserkennung von elektronischen Bauteilen und Anordnung zur Durchführung des Verfahrens.

(30) Priorität: **17.12.84 DE 3445993**

(43) Veröffentlichungstag der Anmeldung:
**25.06.86 Patentblatt 86/26**

(45) Bekanntmachung des Hinweises auf die
Patenterteilung:
**06.11.91 Patentblatt 91/45**

(84) Benannte Vertragsstaaten:
**AT DE**

(56) Entgegenhaltungen:
**DE-A- 3 213 110**

**IBM TECHNICAL DISCLOSURE BULLETIN,
Band 26, Nr. 2, Juli 1983, New York, US; D.S.
ROOP et al.: "Reverse capacitor tester"**

(73) Patentinhaber: **SIEMENS AKTIENGESELL-
SCHAFT
Wittelsbacherplatz 2
W-8000 München 2(DE)**

(72) Erfinder: **Leitz, Eberhardt
Haydnstrasse 82
W-8522 Herzogenaurach(DE)**

**Beschreibung**

Die Erfindung bezieht sich auf Verfahren zur Polaritätserkennung von elektronischen Bauteilen, deren Polarität aus der Bauform nicht erkennbar ist und bei denen einer der beiden elektrischen Anschlüsse mit einem nach außen elektrisch isolierten Außenbelag des Bauteiles verbunden ist, insbesondere zur Polaritätserkennung von Elektrolyt-Kondensatoren, bei welchen Verfahren durch Anlegen von Wechselspannungen an die elektrischen Anschlüsse des Bauteils ein die Polarität des Bauteils festlegendes Signal abgeleitet wird, wobei über den Außenbelag des Bauteiles kapazitiv Ströme fließen. Ein derartiges Verfahren ist bereits aus der DE-A-32 13 110 bekannt. Daneben bezieht sich die Erfindung auch auf eine Anordnung zur Durchführung dieses Verfahrens mit einer Schaltung zur Erzeugung einer vorgegebenen Wechselspannung bzw. von zwei gegeneinander phasenverschobenen Wechselspannungen und zur Auswertung von mittels einer Sonde aufgenommenen Meßsignalen.

Für eine automatische Bestückung von Leiterplatten mit Bauteilen ist Voraussetzung, daß die Bauteile dem Automaten geordnet vorliegen. Diese Bedingung kann durch die Lieferform der Bauteile, beispielsweise durch Gurten, bereits erfüllt sein. Anderenfalls muß der Leiterplattenhersteller die üblicherweise als Schüttgut vorliegenden Bauteile zunächst ordnen, wobei bekannte Verfahren der Vielfachhandhabung oder auch der mechanischen Rüttelförderung angewendet werden können. Bei manchen Bauteilen, insbesondere bei Elektrolyt-Kondensatoren, geht die Polarität nicht aus der Gehäuseform hervor, so daß mechanische Ordnungsverfahren versagen. Es wäre möglich, stattdessen optische Methoden anzuwenden, mit denen insbesondere auch die Beschriftung der Bauteile ausgewertet werden kann. Derartige Methoden sind allerdings vergleichsweise aufwendig.

Es können auch elektrische Methoden angewendet werden, sofern einer der beiden elektrischen Anschlüsse des Bauteiles mit dem elektrisch isolierten Außenbelag des Bauteiles verbunden ist. Letzteres ist insbesondere bei Elektrolyt-Kondensatoren der Fall. Aus der DE-A-32 13 110 ist eine Anordnung zur Ermittlung eines in einer elektrischen Schaltung falsch gepolten Kondensators, z. B. Elektrolyt-Kondensators, unter Anwendung des eingangs genannten Verfahrens bekannt, bei der bei richtig gepolt eingebautem Kondensator die Kondensatoraußenseite als erste Elektrode mit einem ersten Leitungsstück und die im Inneren des Kondensators angeordnete zweite Elektrode mit einem zweiten Leitungsstück verbunden ist. Dabei ist ein an die Kondensatoraußenform angepaßter Prüfbecher aus leitendem Material vorgesehen, der so über den Kondensator gestülpt wird, daß er den Kondensator nicht berührt, wobei der Prüfbecher mit einer ersten Impulsquelle verbunden ist, die Ladeimpulse erzeugt, und wobei zwischen dem Prüfbecher und dem zweiten Leitungsstück ein Schaltelement angeordnet ist, das durch alternierend zu den Ladeimpulsen erzeugte Entladeimpulse durchlässig gesteuert wird. Hierzu liegt das erste Leitungsstück an einem festen Potential (0 V) und es ist ein Komparator vorgesehen, an dessen einem Eingang die zwischen dem ersten und zweiten Leitungsstück bestehende Spannung und an dessen anderem Eingang eine Referenzspannung (UR) anliegt.

Mit letzterer Anordnung kann speziell die Polarität eines in einer elektrische Schaltung bereits fest verdrahteten Elektrolyt-Kondensators geprüft werden. Gleichermaßen ist aus dem Zeitschriftenartikel "IBM Technical Disclosure Bulletin", Vol. 26 No. 2, July 1983, Seite 579 bis 581 eine Testeinrichtung für Kondensatoren bekannt, bei welcher der Kondensator aufgeladen und über einen parallelgeschalteten Testwiderstand entladen wird. Bei einer solchen Anordnung sollen aus der Entladungsstromkurve Kriterien für die Polarität des Kondensators abgeleitet werden.

Aufgabe der Erfindung ist es demgegenüber, Verfahren der eingangs genannten Art anzugeben und die zugehörige Anordnung zu schaffen, mit denen in einfacher Weise an Bauteilen, die nicht verdrahtet als Schüttgut vorliegen, eine Polaritätserkennung erfolgen kann. Dadurch soll insbesondere die polaritätsgerechte Handhabung von Elektrolyt-Kondensatoren durch Bestückroboter ermöglicht werden.

Die Aufgabe ist erfindungsgemäß dadurch gelöst, daß die kapazitiv fließenden Ströme von einer Meßsonde erfaßt und hinsichtlich der Polarität des Bauteiles ausgewertet werden, wobei entweder

- an die elektrischen Anschlüsse abwechselnd eine Wechselspannung gelegt wird und das Differenzsignal der jeweils kapazitiv fließenden Ströme zur Polaritätsbestimmung verwendet wird, wobei der kapazitiv fließende Strom zwischen der Sonde und dem mit dem Außenbelag verbundenen Anschluß größer ist als der kapazitiv fließende Strom zwischen der Sonde und dem anderen Anschluß des Bauteiles,

oder wobei

- an die elektrischen Anschlüsse des Bauteiles gleichzeitig zwei gegeneinander phasenverschobene Wechselspannungen gelegt werden und als Polaritätssignal die Phase des kapazitiv über den Außenbelag des Bauteiles zur Sonde fließenden Stromes angezeigt wird, wobei Frequenz und Amplitude beider Wechselspannungen gleich sind.

Bei beiden alternativen erfindungsgemäßen Verfahren läßt sich also aus den kapazitiv fließenden Strömen unmittelbar das Polaritätssignal für das Bauteil ableiten. Insbesondere das zweite Verfahren kann in einfacher Weise schaltungstechnisch realisiert werden.

Bei einer Anordnung der eingangs genannten Art ist zur Durchführung der erfindungsgemäßen Verfahren die Sonde zur Bildung einer hinreichend großen Kapazität großflächig an die Form des Bauteiles angepaßt, bildet eine Negativform für das Bauteil und ist formschlüssig an das Bauteil anlegbar oder darauf aufsetzbar, und ist der von der Sonde wegführende elektrische Leitungsanschluß zur Vermeidung des Einflusses von Streufeldern elektrisch abgeschirmt.

Mit der Erfindung sind Verfahren und eine zugehörige Anordnung geschaffen, die sich robotergerecht verwenden lassen. Ein für Bauteile ausgebildeter Robotergreifer mit Drehachsen kann in einfacher Weise mit der beschriebenen Sonde komplettiert werden. Liegt die mit dem erfindungsgemäßen Verfahren gewonnene Information über die Lage des Bauteiles vor, wird die Steuerung des Robotergreifers gegebenenfalls veranlaßt, den Greifer vor dem Einsetzen des Bauteiles in die Leiterplatte um 180° zu drehen. Damit ist ohne großen Aufwand immer eine polaritätsgerechte Bestückung der Leiterplatten mit dem Bauteilem möglich.

Weitere Einzelheiten und Vorteile der Erfindung ergeben sich aus der nachfolgenden Figurenbeschreibung von Ausführungsbeispielen anhand der Zeichnung. Es zeigen

Figur 1 ein Blockschaltbild einer Anordnung, an der insbesondere das zweite erfindungsgemäße Verfahren erläutert wird,

Figur 2 eine konkret verwendbare Schaltung zur Durchführung dieses Verfahrens,

Figur 3 ein zur Figur 2 zugehöriges Impulsdiagramm sowie

Figur 4 eine Seitenansicht einer Ausführungsform der Sonde.

Identische Teile sind in den verschiedenen Figuren mit den gleichen Bezugszeichen versehen. Die Figuren werden teilweise zusammen beschrieben.

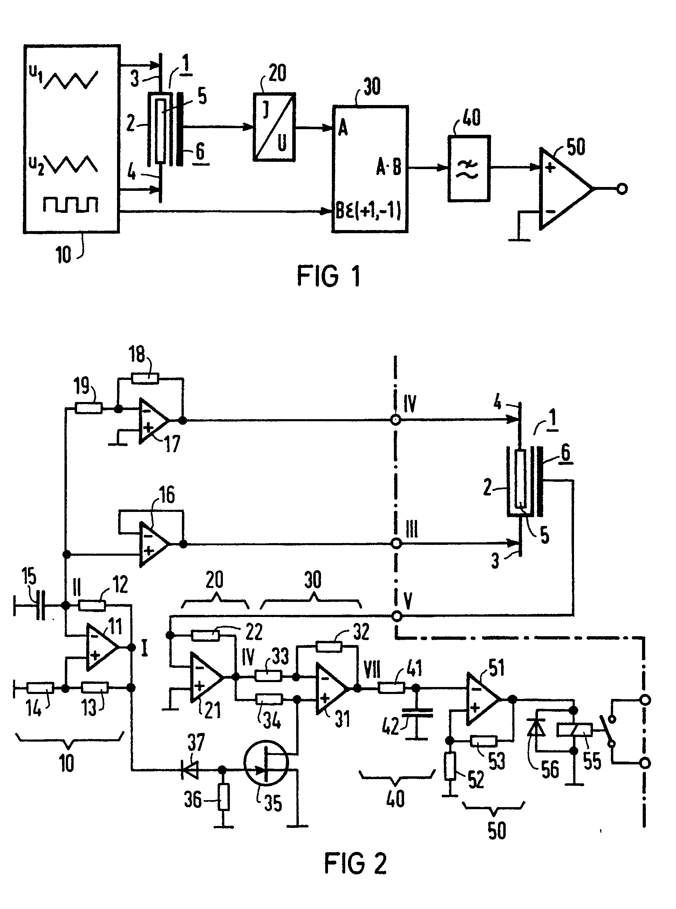

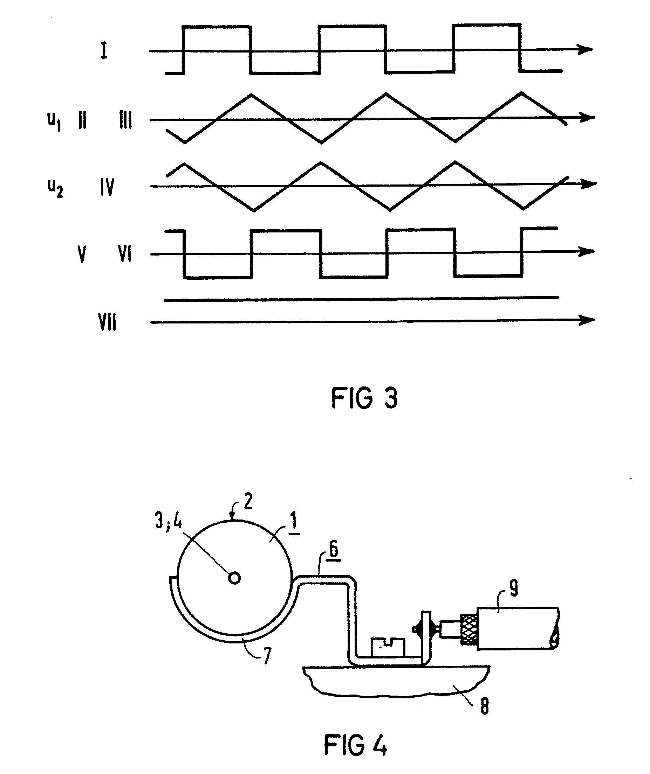

In Figur 1 und 2 ist mit 1 ein elektronisches Bauteil mit elektrischen Anschlüssen 3 und 4 bezeichnet. Voraussetzung für die Durchführbarkeit der nachfolgend beschriebenen Verfahren ist, daß das Bauteil 1 einen Außenbelag 2 hat, der mit einem der elektrischen Anschlüsse bspw. Anschluß 3, verbunden ist. Der andere elektrische Anschluß, Anschluß 4, führt zu einer Elektrode 5 im Innern des Bauteiles 1. Diese Voraussetzungen sind bei einem Elektrolyt-Kondensator mit Außenkathode und innenliegender Anode realisiert. In der Regel ist der Außenbelag 2 eines derartigen Bauteiles 1 nach außen hin elektrisch isoliert. An das Bauteil ist eine Sonde 6 anlegbar, die weiter unten anhand Fig. 4, noch im einzelnen beschrieben wird. Zunächst werden - ohne direkte Bezugnahme auf Fig 1 - die beiden verfahrensalternativen erläutert:

Legt man an die Anode eines beispielhaft verwendeten Kondensators 1 ein Bezugspotential M und an die Kathode eine Wechselspannung u, die selbstverständlich die zulässige Umpolspannung nicht überschreiten darf, so fließt über die Koppelkapazität zwischen der Kathode und der angelegten Sonde 6 ein Strom. Legt man dagegen die Kathode an das Bezugspotential M und die Anode an die Wechselspannung u, so fließt über die Sonde 6 ein kleinerer Strom, da die Kathode als Abschirmung wirkt und somit nur die Streukapazität zwischen der Anode und der Sonde 6 zur Wirkung kommt. Aus dem Wert der Strom amplitude ist also erkennbar, ob die Kathode oder die Anode an der Spannung u liegt, was zur Polaritätsanzeige verwendet werden kann. Allerdings ist die Auswertung der Stromamplitude durch Vergleich mit einem festen Wert unsicher, da der Wert des Stromes von der nicht exakt definierten Kapazität zur Sonde abhängt. Es ist vorteilhafter, die Spannung u abwechselnd einmal an den einen und dann an den anderen Anschluß des Bauteiles zu legen und jeweils den Strom i zu messen. Der größere Wert der beiden Ströme kennzeichnet dann die Messung, bei der die Spannung an der Kathode lag.

Bei Verwendung zweier Wechselspannungen $u_1$ und $u_2$ können die beiden Messungen gleichzeitig durchgeführt werden. Dabei sind die Spannungen $u_1$ und $u_2$ Wechselspannungen gleicher Frequenz und Amplitude und vorteilhafterweise in ihrer Phasenlage um 180° zueinander verschoben. In diesem Fall entspricht die Phase des Sondenstromes immer der Phasenlage derjenigen Spannung, die am Außenbelag und somit an der Kathode liegt. Dabei ist die Phasenverschiebung zwischen Spannung und Strom zu berücksichtigen, die durch die Kapazität zwischen Sonde 6 und den Anschlüssen 3 und 4 des Bauteiles 1 entsteht.

Zur Realisierung letzteren Verfahrens ist in Figur 1 ein Dreieck/Rechteck-Generator 10 dargestellt, der ein Rechtecknormsignal und zwei entsprechende Dreiecksignale erzeugt, von denen eines in der Phase um 180° verschoben ist. Die Signale haben die gleiche Frequenz von ≤ 5 kHz, beispielsweise 1 kHz, und die gleiche Amplitude von ≤1 V, beispielsweise 0,5 V. Die beiden Dreiecksignale werden an die Anschlüsse 3 und 4 des Bauteiles 1 gelegt.

Das mit der Sonde 6 kapazitiv erfaßte Stromsignal wird über einen Strom-Spannungs-Wandler 20 auf den einen Eingang A eines Synchrongleichrichters 30 gegeben. Auf den anderen Eingang B gelangt das Rechtecksignal. In Abhängigkeit vom Rechtecksignal wird das Signal A mit + 1 oder -1 verstärkt und das so aufbereitete Signal auf einen Tiefpaß 40 gegeben, der zusammen mit dem Synchrongleichrichter 30 insbesondere den Einfluß von netzfrequenten Einstreuungen eliminieren soll. Anschließend gelangt das aufbereitete Signal auf einen Komparator 50, der nach Vergleich des Signals mit einem Vergleichswert ein Polaritätssignal liefert, das für Steuerzwecke verwendbar ist.

In der Schaltung nach Figur 2 ist der Generator 10 im einzelnen durch einen Multivibrator aus Verstärker 11 mit zugehörigen Beschaltungswiderständen 12 bis 14 und Kapazität 15 gebildet, der gleichermaßen ein Rechtecksignal sowie ein phasensynchrones, angenähertes Dreiecksignal erzeugt. Das Dreiecksignal gelangt über einen als Impedanzwandler geschalteten Verstärker 16 als Spannung $u_1$ auf den einen Anschluß 3 des Prüflings 1 und über einen Invertierer aus rückgekoppeltem Operationsverstärker 17 und zugehörigen Beschaltungswiderständen 18 und 19 als Spannung $u_2$ auf den anderen Anschluß 4 des als Prüfling bezeichneten Bauteiles 1.

Der von der Sonde 6 am Prüfling 1 kapazitiv erfaßte Strom gelangt über einen Strom-Spannungswandler 20 aus einem mit einem Widerstand 22 rückgekoppelten Operationsverstärker 21 auf den Synchrongleichrichter 30. Dieser besteht in bekannter Weise aus einem Operationsverstärker 31, der mit Widerständen 32 bis 34 beschaltet ist, wobei auf den zweiten Eingang des Operationsverstärkers 31 das Rechtecksignal des Multivibrators 11 bis 15 gegeben wird. Dazu ist diesem Eingang ein Feldeffekttransistor 35 mit Widerstand 36 und Sperrdiode 37 im Eingangszweig vorgeschaltet.

Dem Synchrongleichrichter 30 folgt der Tiefpaß 40 aus Widerstand 41 und Kapazität 42 sowie als Komparator ein Schmitt-Trigger aus Operationsverstärker 51 mit Widerständen 52 und 53. Dem Schmitt-Trigger ist ein Relais 55 mit parallel liegender Sperrdiode 56 nachgeschaltet, mit dem die Signalisierung und Anzeige der Polarität erfolgt.

Im Impulsdiagramm nach Figur 3 sind die an den Schaltungspunkten I bis VII der Fig. 2 anliegenden Signale zeilenweise dargestellt. Zur Ergänzung der Beschreibung von Figur 2 dienen dazu folgende Erläuterungen:

Der Multivibrator 11 bis 15 erzeugt am Punkt I eine Rechteckspannung und am Punkt II annähernd eine Dreieckspannung.

Die Dreiecksspannung wird den Anschlüssen 3 und 4 des Bauteiles 1 über den Impedanzwandler 16 als Meßspannung $u_1$ und über den Invertierer 17 bis 19 als Meßspannung $u_2$ zugeführt. Infolge der Kapazität zwischen dem Außenbelag 2 des Bauteiles 1 und der Sonde 6 und der Streukapazität zwischen dem Innenbelag und der Sonde fließt am Punkt V der Schaltung gemäß Fig 2 ein Strom zum virtuellen Nullpunkt des Strom-Spannungs-Wandlers. Da die Anschlüsse des Bauteiles 1 an gegenphasigen Spannungen $u_1$ und $u_2$ liegen, setzt sich auch der Strom am Punkt V aus zwei gegenphasigen Komponenten zusammen, von denen die Komponente, die vom Außenbelag herrührt, dominiert. Gemäß der Gleichung i = C . du/dt ist der Strom rechteckförmig und hat die im Zeile V von Fig 3 gezeigte Phasenlage, wenn aus Außenbelag 2 die Meßspannung 41 (Signal IV) liegt. Ist das Bauteil 1 umgekehrt angeschlossen, ergibt sich ein gegenphasiger Stromverlauf. Nach der Strom-Spannungswandlung entsteht ein Spannungssignal gemäß Zeile VI von Fig 3, das der Synchrongleichrichter 30 in ein Gleichspannungssignal gemäß Zeile VII umwandelt. Die Polarität dieses Gleichspannungssignals liefert die gewünschte Aussage über die Polarität des Bauteiles.

Da in Fig 3 der Strom- bzw. Spannungsverlauf an den Punkten V und VI von Fig 2 idealisiert dargestellt ist und in der Praxis von Störungen, wie Netzfrequenz u. dgl., überlagert ist, ist die Schaltung des Synchrongleichrichters 30 mit nachgeschaltetem Tiefpaß 40 zur Eliminierung der Störungen notwendig. Es werden nur Signale mit Frequenzen erfaßt, die gleich der Steuerfrequenz oder gleich einem ungradzahligen Vielfachen davon am Punkt I sind.

Der Ausgang des als Vergleicher geschalteten Schmitt-Triggers steuert das Relais 55 in der Weise an, daß der Relais-Kontakt geschlossen ist, wenn der Außenbelag 2 des Bauteiles 1 an der Spannung $u_2$ (Signal gemäß Zeile IV) liegt.

In der Figur 4 ist die Sonde 6 als metallisches Formteil ausgebildet, das in etwa eine Negativform 7 für das darinliegende Bauteil 1 mit den Anschlüssen 3 und 4 bildet.

Von der Negativform 7 der Sonde 6 soll eine möglichst hohe Kapazität mit dem Außenbelag 2 des Bauteiles 1 gebildet werden. Beispielsweise eignet sich für die Aufnahme des Bauteiles 1 ein Flachbandmaterial. Die Sonde 6 kann aber auch in kompakter Form ausgebildet sein, die insbesondere in Verbindung mit einem Robotergreifer unter Federdruck beim Greifen des Bauteiles 1 von oben auf das Bauteil aufgesetzt wird. Rückseitig ist das Formteil 7 der Sonde 6 entsprechend den jeweils vorliegenden Bedürfnissen beispielsweise an einem Isolator 8 angeschraubt, von wo eine abgeschirmte Leitung 9 weggeführt wird. Die leitenden Teile der Sonde 6, die nicht zur Kapazität mit dem Außenbelag beitragen und nicht abgeschirmt sind, werden dabei möglichst klein ausgeführt, um störende Einstreuungen möglichst gering zu halten.

Die beschriebenen Verfahren und die zugehörige Anordnung können zur Polaritätserkennung von solchen Elektrolyt-Kondensatoren verwendet werden, die einerseits einen Außenbelag aufweisen und die andererseits Umpolspannungen zulassen, die üblicherweise bei 1 V und einer Frequenz von 1 kHz liegen. Diese Voraussetzungen sind bei Aluminium- und Tantal-Elektrolytkondensatoren im allgemeinen gegeben. Mit dem beschriebenen Verfahren ist daneben auch die Erkennung des Außenbelages von ungepolten Kondensatoren möglich.

**Patentansprüche**

1. Verfahren Zur Polaritätserkennung von elektronischen Bauteilen (1), deren Polarität aus der Bauform nicht erkennbar ist und bei denen einer (3) der beiden elektrischen Anschlüsse (3, 4) mit einem nach außen elektrisch isolierten Außenbelag (2) des Bauteiles (1) verbunden ist, insbesondere zur Polaritätserkennung von Elektrolyt-Kondensatoren, bei welchen Verfahren durch Anlegen von Wechselspannung (u; $u_1$, $u_2$) an die elektrischen Anschlüsse (3, 4) des Bauteiles (1) ein die Polarität des Bauteiles (1) festlegendes Signal abgeleitet wird, wobei über den Außenbelag (2) des Bauteiles (1) kapazitiv Ströme fließen, **dadurch gekennzeichnet,** daß die kapazitiv fließenden Ströme von einer Meßsonde (6) erfaßt und hinsichtlich der Polarität des Bauteiles (1) ausgewertet werden wobei entweder
   - an die elektrischen Anschlüsse (3, 4) abwechselnd eine Wechselspannung (u) gelegt wird und das Differenzsignal der jeweils kapazitiv fließenden Ströme zur Polaritätsbestimmung verwendet wird, wobei der kapazitiv fließende Strom zwischen der Sonde (6) und dem mit dem Außenbelag (2) verbundenen Anschluß (3) größer ist als der kapazitiv fließende Strom zwischen der Sonde (6) und dem anderen Anschluß (4) des Bauteiles (1),
   oder wobei
   - an die elektrischen Anschlüsse (3, 4) des Bauteiles (1) gleichzeitig zwei gegeneinander phasenverschobene Wechselspannungen ($u_1$, $u_2$) gelegt werden und als Polaritätssignal die Phase des kapazitiv über den Außenbelag (2) des Bauteiles (1) zur Sonde (6) fließenden Stromes angezeigt wird, wobei Frequenz und Amplitude beider Wechselspannungen ($u_1$, $u_2$) gleich sind.

2. Verfahren nach Anspruch 1 , **dadurch gekennzeichnet,** daß die Phasenverschiebung der beiden Wechselspannungen ($u_1$, $u_2$) 180° ist.

3. Verfahren nach Anspruch 1 , **dadurch gekennzeichnet,** daß die beiden Wechselspannungen ($u_1$, $u_2$) Dreiecksspannungen sind.

4. Verfahren nach Anspruch 1 , **dadurch gekennzeichnet,** daß die Frequenz der beiden Wechselspannungen ($u_1$, $u_2$) kleiner 5 kHz, vorzugsweise 1 kHz, ist und die Amplitude einen Wert von kleiner 1 V, vorzugsweise 0,5 V, hat.

5. Anordnung zur Durchführung eines Verfahrens zur Erkennung der Polarität von elektronischen Bauteilen (1) nach Anspruch 1 oder einem der Ansprüche 2 bis 4, mit einer Schaltung zur Erzeugung einer vorgegebenen Wechselspannung (u) bzw. von gegeneinander phasenverschobenen Wechselspannungen ($u_1$, $u_2$) und zur Auswertung von mittels einer Sonde (6) aufgenommenen Meßsignalen, **dadurch gekennzeichnet,** daß die Sonde (6) zur Bildung einer hinreichend großen Kapazität großflächig an die Form des Bauteiles (1) angepaßt ist, eine Negativform (1) für das Bauteil bildet und formschlüssig an das Bauteil (1) anlegbar oder darauf aufsetzbar ist und daß der von der Sonde (6) wegführende elektrische Leitungsanschluß (9) zur Vermeidung des Einflusses von Streufeldern elektrisch abgeschirmt ist.

6. Anordnung nach Anspruch 5, **dadurch gekennzeichnet,** daß die Schaltung zur Erzeugung der phasenverschobenen Wechselspannungen ($u_1$, $u_2$) und zur Auswertung der Meß-Signale im wesentlichen aus einem Multivibrator (11 bis 15) zur Erzeugung eines Rechtecksignals und einer dazu synchronen Dreiecksspannung ($u_1$, $u_2$) besteht, deren Phase ein Invertierer (17 bis 19) umkehrt.

7. Anordnung nach Anspruch 6, **dadurch gekennzeichnet,** daß der Multivibrator (11 bis 15) gleichermaßen zur Definition eines Vergleichssignals dient.

8. Anordnung nach Anspruch 6, **dadurch gekennzeichnet,** daß ein Synchrongleichrichter (31 bis 37) mit Verstärkerstufe (21 bis 22) vorhanden ist, mit dem das Meßsignal der Sonde (6) in Abhängigkeit eines vom Multivibrator (11 bis 15) gelieferten Steuersignals zur Bildung des Polaritätssignals gleichgerichtet und verstärkt wird.

9. Anordnung nach Anspruch 8, **dadurch gekennzeichnet,** daß dem Synchrongleichrichter (31 bis 37) ein Tiefpaß (41 bis 42) nachgeschaltet ist, wodurch insbesondere durch Netzfrequenz verursachte Störungen eliminiert werden.

10. Anordnung nach Anspruch 9, **dadurch gekennzeichnet,** daß dem Synchrongleichrichter (31 bis 37) und Tiefpaß (41 bis 42) ein Komparator (50) nachgeschaltet ist, der das Polaritätssignal liefert.

## Claims

1. A method for polarity recognition of electronic components (1), in particular for polarity recognition of electrolyte capacitors, the polarity of which is not able to be recognised from the structural form, and in which one (3) of two electrical terminals (3,4) is connected to an outer coat (2), of the component (1), which is electrically insulated at its exterior, and in which method by applying alternating voltage ($u; u_1, u_2$) to the electrical terminals (3,4) of the component (1) a signal is derived determining the polarity of the component (1), there being capacitive currents which flow over the outer coat (2) of the component (1), characterised in that the capacitive flowing currents are detected by a measuring probe (6) and are evaluated with regard to the polarity of the component (1), wherein either
   - an alternating voltage (u) is applied alternately to the electrical terminals (3,4) and the difference signal of the respective capacitive flowing currents is used for determining the polarity, wherein the capacitive flowing current between the probe (6) and the terminal (3) connected to the outer coat (2) is greater than the capacitive flowing current between the probe (6) and the other terminal (4) of the component (1),
   or wherein
   - applied simultaneously to the electrical terminals (3,4) of the component (1) there are two alternating voltages ($u_1, u_2$) phase-displaced relative to each other and the phase of the capacitive current flowing by way of the outer coat (2) of the component to the probe (6) is indicated as polarity signal, wherein the frequency and amplitude of both alternating voltages ($u_1, u_2$) are equal.

2. A method according to claim 1, characterised in that the phase displacement of both alternating voltages ($u_1, u_2$) is 180°.

3. A method according to claim 1, characterised in that both alternating voltages ($u_1, u_2$) are triangular voltages.

4. A method according to claim 1, characterised in that the frequency of both alternating voltages ($u_1, u_2$) is less than 5 kHz, preferably 1kHz, and the amplitude has a value of less than 1 V, preferably 0.5 V.

5. An arrangement for carrying-out a method for recognising the polarity of electronic components (1), according to claim 1 or one of claims 2 to 4, with a circuit for generating a predetermined alternating voltage (u) or alternating voltages ($u_1, u_2$) phase-displaced relative to each other, and for evaluating measured signals detected by means of a probe (6), characterised in that the probe (6) is adapted to the shape of the component (1) for forming a sufficiently large capacitance over a large area, forms a negative-form (1) for the component and is able to be applied in a form-locking manner to the component (1) or placed thereon, and in that the electrical line terminal (9) leading away from the probe (6) is electrically shielded to avoid the influence of stray fields.

6. An arrangement according to claim 5, characterised in that the circuit for generating the phase-displaced alternating voltages ($u_1, u_2$) and for evaluating the measured signals consists substantially of a multivibrator (11 to 15) for the generation of a square-wave signal and a triangular voltage ($u_1, u_2$) synchronous thereto, the phase of which is reversed by an inverter (17 to 19).

7. An arrangement according to claim 6, characterised in that the multivibrator (11 to 15) serves in the same way for defining a comparative signal.

8. An arrangement according to claim 6, characterised in that a synchronous rectifier (31 to 37) with an amplifying stage (21 to 22) is provided, with which the measured signal of the probe (6) is rectified and amplified in dependence on a control signal delivered by the multivibrator (11 to 15) for forming the polarity signal.

9. An arrangement according to claim 8, characterised in that downstream of the synchronous rectifier (31 to 37) there is a low-pass filter (41 to 42), with which in particular interferences caused by a line frequency are eliminated.

10. An arrangement according to claim 9, characterised in that downstream of the synchronous rectifier (31 to 37) and low-pass filter (41 to 42) there is a comparator (50), which delivers the polarity signal.

**Revendications**

1. Procédé pour déterminer la polarité de composants électroniques (1), dont la polarité ne peut pas être identifiée à partir de la forme de réalisation et dans lesquels l'une (3) des deux bornes électriques (3,4) est raccordée à une armature extérieure (2), électriquement isolée vis-à-vis de l'extérieur, des composants (1), notamment pour déterminer la polarité de condensateurs électrolytiques, et selon lequel un signal déterminant la polarité du composant (1) est obtenu au moyen de l'application d'une tension alternative (u; u$_1$, u$_2$) aux bornes électriques (3,4) du composant (1), des courants circulant par effet capacitif dans l'armature extérieure (2) du composant (1), caractérisé par le fait que les courants circulant par effet capacitif sont détectés par une sonde de mesure (6) et sont évalués pour déterminer la polarité du composant (1), auquel cas soit

   - on applique une tension alternative (u) alternativement aux bornes électriques (3,4) et on utilise le signal différentiel des courants circulant respectivement par effet capacitif pour déterminer la polarité, le courant circulant par effet capacitif entre la sonde (6) et la borne (3) raccordée à l'armature extérieure (2) étant supérieur au courant, qui circule par effet capacitif, entre la sonde (6) et l'autre borne (4) du composant (1),
   soit
   - on applique simultanément deux tensions alternatives réciproquement déphasées (u$_1$,u$_2$) aux bornes électriques (3,4) du composant (1), et, la phase du courant circulant par effet capacitif dans l'armature extérieure (2) du composant (1) en direction de la fente (6) est affichée en tant que signal de polarité, la fréquence et l'amplitude des deux tensions alternatives (u$_1$,u$_2$) étant identiques.

2. Procédé suivant la revendication 1, caractérisé par le fait que le déphasage des deux tensions alternatives (u$_1$,u$_2$) est égal à 180°.

3. Procédé suivant la revendication 1, caractérisé par le fait que les deux tensions alternatives (u$_1$,u$_2$) sont des tensions triangulaires.

4. Procédé suivant la revendication 1, caractérisé par le fait que la fréquence des deux tensions alternatives (u$_1$,u$_2$) est inférieure à 5 kHz, de préférence 1 kHz et l'amplitude possède une valeur inférieure à 1 V, de préférence 0,5 V.

5. Montage pour la mise en oeuvre du procédé pour déterminer la polarité de composants électroniques (1) suivant la revendication 1 ou l'une des revendications 2 à 4, comportant un circuit pour produire une tension alternative prédéterminée (u) ou des tensions alternatives réciproquement déphasées (u$_1$,u$_2$) et évaluer des signaux de mesure reçus par une sonde (6), caractérisé par le fait que la sonde (6) est adaptée, sur une surface étendue, à la forme du composant (1) pour former une capacité suffisamment élevée, forme un modèle négatif (1) du composant et peut être appliquée ou posée sur le composant (1) avec une configuration de forme complémentaire et que la borne électrique (9), qui part de la sonde (6), est blindée électriquement de manière à éviter l'influence de champs de fuite.

6. Dispositif suivant la revendication 5, caractérisé par le fait que le circuit servant à produire les tensions alternatives déphasées (u$_1$,u$_2$) et à évaluer les signaux de mesure est constitué essentiellement par un multivibrateur (11 à 15) servant à produire un signal rectangulaire et une tension triangulaire (u$_1$,u$_2$), synchrone de ce signal et dont la phase est inversée par un inverseur (17 à 19).

7. Dispositif suivant la revendication 6, caractérisé par le fait que le multivibrateur (11 à 15) est également utilisé pour définir un signal de comparaison.

8. Dispositif suivant la revendication 6, caractérisé par le fait qu'il est prévu un redresseur synchrone (31 à 37) comportant un étage amplificateur (21 à 22) et à l'aide duquel le signal de mesure de la sonde (6) est redressé et amplifié en fonction d'un signal de commande délivré par le multiplivibrateur (11 à 15), pour former le signal de polarité.

9. Dispositif suivant la revendication 8, caractérisé par le fait qu'en aval du redresseur synchrone (31 à 37) est branché un filtre passe-bas (41 à 42), ce qui permet l'élimination notamment de perturbations provoquées par la fréquence du secteur.

10. Dispositif suivant la revendication 9, caractérisé par le fait qu'en aval du redresseur synchrone (31 à 37) et du filtre passe-bas (41 à 42) est branché un comparateur (50) qui délivre le signal de polarité.

EP 0 185 255 B1

FIG 1

FIG 2

FIG 3

FIG 4